# EUROPEAN PATENT SPECIFICATION

(11) **EP 1 779 196 B1**
(45) Date of publication and mention of the grant of the patent: **09.10.2013**
(21) Application number: 05762611.1
(22) Date of filing: 15.06.2005
(51) Int. Cl.: G03F 7/027, G03F 7/00, G03F 7/032

(54) **BINDER-FREE PHOTOPOLYMERIZABLE COMPOSITIONS**
BINDERFREIE PHOTOPOLYMERISIERBARE ZUSAMMENSETZUNGEN
COMPOSITIONS PHOTOPOLYMERISABLES SANS LIANT

(30) Priority: 15.06.2004 GB 0413366
(43) Date of publication of application: 02.05.2007
(73) Proprietor: Xetos AG, 85662 Hohenbrunn (DE)
(72) Inventor: Knocke, Frank, 85560 Ebersberg (DE)
(74) Representative: Beckmann, Claus
(86) International application number: PCT/EP2005/006438
(87) International publication number: WO 2005/124460

(56) References cited:
- EP-A- 0 361 409
- WO-A-03/046661
- DE-A1- 4 039 382
- GB-A- 1 550 882
- GB-A- 2 272 306
- US-A- 4 268 576
- US-A- 4 716 094
- US-A- 5 972 563
- DATABASE WPI Section Ch, Week 199107 Derwent Publications Ltd., London, GB; Class A97, AN 1991-047357 XP002349937 & JP 02 311570 A (BROTHER IND CO LTD) 27 December 1990 (1990-12-27) & JP 02 311570 A (BROTHER IND. CO. LTD.) 27 December 1990 (1990-12-27)
- DATABASE WPI Section Ch, Week 200162 Derwent Publications Ltd., London, GB; Class A89, AN 2001-552346 XP002349938 & JP 2001 117226 A (NIPPON SYNTHETIC CHEM IND CO) 27 April 2001 (2001-04-27) & JP 2001 117226 A (NIPPON SYNTHETIC CHEM IND CO) 27 April 2001 (2001-04-27)

## Description

The invention relates to a binder-free photopolymerizable composition, a photosensitive element comprising said photopolymerizable composition, and a process for preparing a refractive index image, in particular a hologram,

### Background of the invention

A variety of photopolymerizable compositions are known which can be employed for refractive index images, such as holograms.

The term "image recording" is conventionally taken to mean a process which produces a spatial pattern of optical absorption in the recording medium. Photographic processes are well known examples of this type of process.

In a broader sense, however, the word "image" means a spatial variation of the optical properties of a sample in such a way as to cause a desired modification of a beam of light passing through the sample. Refractive index images in general, and holograms in particular, which modulate the phase, rather than the amplitude of the beam passing through them, are usually referred to as phase holograms. Phase holographic image recording systems produce a spatial pattern of varying refractive index rather than optical absorption in the recording medium and, thus, can modulate a beam of light without absorbing it.

This type of refractive index image also includes a number of optical elements or devices which superficially bear little resemblance to absorption images. Examples are holographic lenses, gratings, mirrors, and optical waveguides.

Holography is a form of optical information storage. The general principles are described in a number of references, e.g., "Photography by Laser" by E. N. Leith and J. Upatnieks in SCIENTIFIC AMERICAN, 212, No. 6, 24-35 (June, 1965). In brief, the object to be photographed or imaged is illuminated with coherent light, e.g., from a laser and a light sensitive recording medium, e.g., a photographic plate, is positioned so as to receive light reflected from the object. Each point on the object reflects light to the entire recording medium, and each point on the medium receives light from the entire object. This beam of reflected light is known as the object beam. At the same time, a portion of the coherent light is beamed by a mirror directly to the medium, bypassing the object. This beam is known as the reference beam. What is recorded on the recording medium is the interference pattern that results from the interaction of the reference beam and the object beam impinging on the medium. When the processed recording medium is subsequently illuminated and observed appropriately, the light from the illuminating source is diffracted by the hologram to reproduce the wave-front that originally reached the medium from the object, so that the hologram resembles a window through which the virtual image of the object is observed in full three-dimensional form, complete with parallax.

Holograms that are formed by allowing the reference and object beams to enter the recording medium from the same side are known as transmission holograms. Interaction of the object and reference beams in the recording medium forms fringes of material with varying refractive indices which are normal or near normal to the plane of the recording medium. When the hologram is played back by viewing with transmitted light, these fringes refract the light to produce the viewed virtual image. Such transmission holograms may be produced by methods which are well known in the art such as disclosed in U.S. Patent 3,506,327, U.S. Patent 3,838,903 and U.S. Patent 3,894,787.

Holograms formed by allowing the reference and object beams to enter the recording medium from opposite sides, so that they are traveling in approximately opposite directions are known as reflection holograms. Interaction of the object and reference beams in the recording medium forms fringes of material with varying refractive indices which are, approximately, planes parallel to the plane of the recording medium. When the hologram is played back these fringes act as mirrors reflecting incident light back to the viewer. Hence, the hologram is viewed in reflection rather than in transmission. Since the wavelength sensitivity of this type of hologram is very high, white light may be used for reconstruction. Reflection holograms produced by an off-axis process are disclosed in U.S. Patent 3,532,406.

A diffraction grating is the simplest possible transmission hologram. It is the hologram of two coherent plane waves. It can be created by splitting a single laser beam and recombining the beams at the recording medium.

The interference pattern produced by two plane waves which are coherent and are not polarized perpendicular to each other is a set of uniformly spaced fringes with a sinusoidal intensity distribution. When incident on a recording medium they produce a set of uniformly spaced fringes which have a sinusoidal variation in refractive index, generally referred to as a grating, oriented parallel to the bisector of the angle between the two beams. If the two waves are incident at equal angles with respect to the surface of the recording medium and are both incident on the same side of the recording medium, the fringes are perpendicular to the surface of the medium and the grating is said to be unslanted. The hologram grating produced is said to be a transmission grating since light passing through it is diffracted. The grating is said to be thick if it is much thicker than the distance between the fringes, generally referred to as the grating spacing.

A diffraction grating can be characterized by its diffraction efficiency, that is the percent of incident radiation which is diffracted, and by its thickness. A simple but useful theory for thick hologram gratings, generally known as the "coupled wave theory", has been developed by Kogelnik (H. Kogelnik. "Coupled wave theory for thick hologram gratings", Bell Syt. Tech. J., 48. 2909-2947. 1969). This theory treats the relationship between diffraction efficiency, grating thickness, wavelength of incident radiation, and the angle of incident radiation. A useful discussion of this theory in regard to refractive index recording systems has been presented in Section II of an article by Tomlinson and Chandross (W. J. Tomlinson and E. A. Chandross, "Organic photochemical refractive-index image recording systems", Adv. in Photochem., Vol. 12, J. N. Pitts, Jr., G. S. Hammond, and K. Gollinick, eds., Wiley-Interscience, New York, 1980, pp 201-281).

Refractive index modulation is a quantitative measure of the change in refractive index between image and non-image portions of a hologram or other recording medium containing a refractive index image. For the diffraction grating, refractive index modulation is the measure of the amplitude of the sinusoidal modulation of the refractive index within the recording medium produced when the holographic image is recorded. The refractive index modulation, or index modulation, for a recording medium is best determined by holographically forming a grating in the medium and calculating the index modulation using Kogelnik's coupled wave theory and the measured parameters of the grating formed, i.e., the diffraction efficiently, medium thicknesses, etc.

A variety of materials have been used to record volume holograms. Among the more important are: silver halide emulsions, hardened dichromated gelatin, ferroelectric crystals, photopolymers, photochromics and photodichroics. Characteristics of these materials are given in Volume Holography and Volume Gratings, Academic Press, New York, 1981 Chapter 10, pp. 254-304 by L. Solymar and D. J. Cook.

Dichromated gelatin is the material most widely used for recording volume holograms. This material has become the popular choice because of its high diffraction efficiency and low noise characteristics. However, the material has poor shelf life and requires wet processing. Plates must be freshly prepared, or prehardened gelatin must be used. Wet processing means that an additional step is required in hologram preparation and may also cause the hologram to change due to swelling and then shrinkage of the gelatin during processing. The requirement that plates by freshly prepared each time a hologram is made, plus the problems associated with wet processing, make reproducibly extremely difficult to achieve with dichromated gelatin.

While early holograms were prepared from silver halide, liquid photopolymers, or dichromated colloids which required several processing steps, solid photopolymerizable elements have been proposed that require only a single process step. U.S. Patent 3,658,526 discloses preparation of stable high-resolution holograms from solid photopolymerizable layers by a single step-process wherein a permanent refractive index image is obtained by a single imagewise exposure of the photopolymerizable layer to actinic radiation bearing holographic information. The holographic image formed is not destroyed by subsequent uniform actinic exposure, but rather is fixed or enhanced.

A number of references describe specific photopolymerizable compositions that are stated to be suitable for refractive index imaging. Examples of such references are EP-A-324 480, EP-A-324 481, EP-A-324 482 and WO 03/036389. The photopolymerizable compositions described in these references comprise a polymeric binder, a liquid ethylenically unsaturated monomer and a photoinitiator system.

A binder-free photopolymerizable composition is described in WO 00/67073. The application describes three variants of a photopolymerizable composition that contains photopolymerizable compounds, fixator compounds and an initiator system. In a first variant of this composition, the photopolymerizable compounds consist of α-methacryloyloxy-ω-methacryloyloligo(oxyethylene) (TGM-3) and of α,ω-bis-(methacryloyloxyethyleneoxycarbonyloxyethylene)-oxyethylene (OCM-2). In the second variant, the polymerizable compounds consist of TGM-3 and of α,ω-bis-acryloyl(propyleneglycol)-2,4-toluylenediurethane (APGT), while in the third variant they consist of a mixture of TGM-3, OCM-2 and α-methacryloyl-ω-methacryloyldiethyleneglycoloxyoligo-(diethyleneglycolphthalate) (MDP-2). In the three variants of this composition, the fixator compound consists of α-bromonaphthaline. In the first variant of the composition, the initiator system comprises a dye-sensitizer consisting of eosine and an electron donor that consists of dimethylaminoethanol, while in the second variant it comprises eosine and an electron donor consisting of bis-(4-dimethylaminophenyl)ketone (Michler's ketone), and in the third variant it comprises 1,7,7-trimethylbicyclo[2,2,1]heptanone-2 (camphorquinone), Michler's ketone and methylene blue. An article describing self-developing polymer compositions for holography has been published by one of the inventors of the PCT application in SPIE Int. Techn. Group Newsletter (February 2004).

GB 1 550 882 A describes a process for the formation of a relief image which comprises exposing a layer of a photosensitive composition provided on the surface of a support material to light through a negative to cure the photosensitive composition at the exposed area and removing the non-cured photosensitive composition at the non-exposed area by suction developments wherein the photosensitive composition is a liquid composition comprising as the only essential components, and in the absence of a polymeric binder, at least one addition polymerizable unsaturated monomer having at least one acryloyl or methacryloyl group per molecule and a molecular weight of not more than 100 per acryloyl or methacryloyl group (for example glycerol triacetate and glycerol tributyrate) and at least one photopolymerization initiator.

DE 40 39 382 A describes a modeling liquid for building up of dental porcelain which contains (A) a photopolymerizable compound with at least one C=C bond, (B) a photopolymerization initiator, (C) a reducing agent, and (D) a polymerization inhibitor. Further components include (E) an organic solvent, (F) (semi)solid organic material, (G) a tertiary amine and (H) an organic halo compound. Preferred components are: (A) a mono-or poly-functional (meth)acrylate, (B) an alpha-diketone, ketal benzolin alkyl ether, or derivative, in an amount of 0,001-15 wt% with respect to (A), (C) 0.001-20% of reducing agent, (E) a (halo)hydro-carbon, alcohol, ether, ketone, ester, or a N compound, (F) natural wax, petroleum wax, synthetic wax based on C, polyolefins, or fats and oils, (G) 0.05-5% of a tertiary amine, and (H) 0.01-5% of halo compound. Some of the examples of this document disclose the use of hydrogenated castor oil.

US 5 972 563 A describes a liquid, radiation-curable composition which in addition to a liquid, free-radically polymerizable component comprises at least the following additional components: (A) from 40 to 80 percent by weight of a liquid difunctional or more highly functional epoxy resin or of a liquid mixture consisting of difunctional or more highly functional epoxy resins; (B) from 0.1 to 10 percent by weight of a cationic photoinitiator or of a mixture of cationic photoinitiators; and (C) from 0.1 to 10 percent by weight of a free-radical photoinitiator or of a mixture of free-radical photoinitiators; and (D) up to 40 percent by weight of a hydroxy compound; the free-radically polymerizable component comprises at least (E) from 4 to 30 percent by weight of at least one liquid poly(meth)acrylate having a (meth)acrylate functionality of more than 2; and at least one of components (A) and (D) comprises substances which have aromatic carbon rings in their molecule. The composition is particularly suitable for stereolithography, a particular feature of this composition being that it leads to cured material which exhibits only a very low propensity for uptake of water. In Examples 13 of US 5 972 563 A, castor oil is used in combination with monomer components "Sartomer SR 399" (i.e., dipentaerythritol monohydroxypentaacrylate) and "Novacure 3700" (i.e. bisphenol A diglycidyl ether diacrylate) (cf. Tables in columns 19 and 15). However, none of these is comprised by the definition of the ethylenically unsaturated monomer as defined in claim 1.

There remains a need for an improved photopolymerizable composition which is suitable for refractive index imaging. In particular, the photopolymerizable composition should not require heating for fixation of the refractive index image.

### Summary of the invention

The invention provides a binder-free photopolymerizable composition as defined in claim 1.

Furthermore, the invention provides a process for preparing a refractive index image as defined in claim 13.

A photosensitive element comprising a substrate and a layer of the photopolymerizable composition according to the invention is also disclosed.

Finally, a refractive index image, in particular a hologram, obtainable by the above process is also disclosed.

### Detailed description of the invention

The present invention relates to a binder-free photopolymerizable composition with the ingredients as defined in claim 1, which generally comprises:
(i) at least one ethylenically unsaturated monomer;
(ii) a photoinitiator system; and
(iii) at least one organic component;

Preferably the absolute value of the difference in refractive index between the at least one ethylenically unsaturated monomer and the at least one organic component is at least 0.065.

The present invention also relates to a process for preparing a refractive index image as defined in claim 13.

The present photopolymerizable compositions are binder-free. This means that the photopolymerizable composition as such (i.e. before polymerization of the monomer) does not contain a polymeric binder.

### Component (i): Ethylenically unsaturated monomer

The ethylenically unsaturated monomer contained in the composition according to the invention is defined in claim 1.

Component (i) of the photopolymerizable composition used in the process according to the invention is an ethylenically unsaturated monomer.

The ethylenically unsaturated monomer used in the process of claim 13 is not particularly restricted. Preferably the ethylenically unsaturated monomer has at least two unsaturations, more preferably two or three unsaturations. If the ethylenically unsaturated monomer has three or more unsaturations it will result in a three-dimensional crosslinked structure upon irradiation. This can stabilize the Bragg planes that are formed upon irradiation. Furthermore, the speed of crosslinking and the quality of the crosslinked structure are improved.

Examples of suitable ethylenically unsaturated monomers include styrene, isopropenyl benzene and derivatives thereof and (meth)acrylates.

Specific examples of suitable styrenes include styrene or substituted derivatives thereof. Specific examples of suitable isopropenyl benzenes include isopropenyl benzene or substituted derivatives thereof. Substituted derivatives of styrene and of isopropenyl benzene can have 1 to 4 substituents, preferably 1 or 2 substituents. Preferred substituents are selected from the group consisting of halogens, C₁₋₄ alkyl groups, C₁₋₄ alkoxy groups, hydroxy group, vinyl group, and isopropenyl groups. Specific examples include styrene, 2-chlorostyrene, 2-bromostyrene, methoxystyrene, 1,4-diisopropenyl benzene, and 1,3,5-triisopropenyl benzene.

(Meth)acrylates which can be used as the ethylenically unsaturated monomer preferably have the general formula 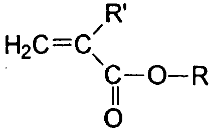 wherein R' is H or CH₃ and R is a group selected from the group consisting of C₁₋₁₂ alkyl groups optionally substituted with one or two substituents R²; C₆₋₁₂ aryl groups optionally substituted with one or two substituents R³; aralkyl groups wherein the aryl portion has 6 to 12 carbon atoms and is optionally substituted with R³ and the alkyl portion has 1 to 4 carbon atoms; aryloxyalkyl groups wherein the aryl portion has 6 to 12 carbon atoms and is optionally substituted with R³ and the alkyl portion has 1 to 4 carbon atoms; and C₆₋₁₂ heterocycles having one or two rings including one or more heteroatoms selected from nitrogen, oxygen and sulfur. Preferred alkyl groups are C₁₋₄ alkyl groups. Preferred aryl groups are optionally substituted phenyl groups and optionally substituted naphthyl groups. Preferred heterocycles are heterocycles, which have 5 or 6 ring atoms and include one or more heteroatoms selected from O, N or S.

The substituent R² can be selected from the group consisting of halogen, hydroxy or C₁₋₄ alkoxy.

The substituent R³ can be selected from the group consisting of halogen or hydroxy.

Specific examples include phenyl acrylate, p-chlorophenyl acrylate, 2-phenylethyl acrylate, 2-phenoxyethyl acrylate, 2-p-chlorophenoxy)-ethyl acrylate, phenol ethoxylate acrylate, benzyl acrylate, 2-(1-naphthyloxy)ethyl acrylate, hydroquinone monoacrylate, 2-[β-(N-carbazyl)propionyloxy]ethyl acrylate as well as the corresponding methacrylates.

In addition to mono(meth)acrylates usable in the process of claim 13 di- and higher functional acrylates can be employed as defined in claim 1. These have the general formula 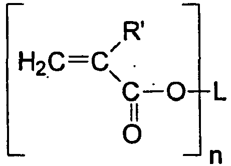 wherein
n is typically 2 to 4; preferably n is 2;
R' is hydrogen or CH₃; and
L is an organic linking group.

Typical examples of L are

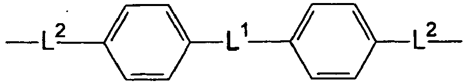

The phenyl rings can be optionally substituted by one or more substituents selected from the group consisting of halogen, C₁₋₄-alkyl, C₁₋₄-alkoxy or hydroxy. Preferably the phenyl rings are unsubstituted or are substituted by one halogen atom.

L¹ is a covalent bond or a straight or branched C₁₋₄ alkylene group. Preferred examples of L¹ are a covalent bond, -CH₂- and -C(CH₃)₂-.

L² is a covalent bond, a straight or branched C₁₋₄ alkylene group optionally substituted by hydroxy, or -[L³-O]ₘ- with L³ being a C₁₋₄ alkylene group and m being 1 to 40. In a preferred embodiment L² is a covalent bond, -CH₂-CH(OH)-CH₂-O- or -[L³-O]ₘ-.

In a preferred embodiment L³ is a straight or branched C₁₋₄ alkylene group. Alkylene groups include methylene, ethylene, propylene and butylene groups. Preferred are ethylene and propylene, even more preferred is ethylene.

In a preferred embodiment m is 2 to 30; more preferably 3 to 10 and even more preferably 3 to 5.

Specific examples are 2,2-di(p-hydroxyphenyl)-propane diacrylate, polyoxyethyl-2,2-di(p-hydroxyphenyl)-propane diacrylate, di(3-acryloxy-2-hydroxypropyl) ether of bisphenol-A, di(2-acryloxyethyl) ether of bisphenol-A, ethoxylated bisphenol-A diacrylate, di(3-acryloxy-2-hydroxypropyl) ether of tetrachloro-bisphenol-A, di(2-acryloxyethyl) ether of tetrachloro-bisphenol-A, di-(3-acryloxy-2-hydroxypropyl) ether of tetrabromo-bisphenol-A, di-(2-acryloxyethyl) ether of tetrabromo-bisphenol-A, di-(3-acryloxy-2-hydroxypropyl) ether of diphenolic acid, 1,4-benzenediol diacrylate, and the corresponding methacrylates.

In a preferred embodiment of the invention, the ethylenically unsaturated monomer is a di- or tri-(meth)acrylate 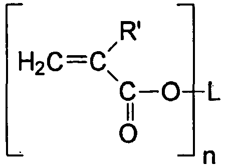 (i.e. n = 2 or 3 and R' and L are as defined above).

In an even more preferred embodiment, the ethylenically unsaturated monomer is a di- or tri-(meth)acrylate with 2 to 30 C₁₋₄ alkoxy units, preferably 3 to 10 C₁₋₄ alkoxy units, even more preferably 3 to 5 C₁₋₄ alkoxy units. The C₁₋₄ alkoxy units include methoxy, ethoxy, propoxy and butoxy units and are preferably ethoxy or propoxy units, even more preferably ethoxy units. The di- or tri-(meth)acrylate preferably also comprises a bisphenol moiety, more preferably a bisphenol A moiety. Bisphenol A poly-(meth)acrylates with various degrees of alkoxylation are, e.g., available from ATOFINA, Exton, PA, USA under the trade designation SARTOMER. Preferred SARTOMER compounds are SR349 (bisphenol A diacrylate with 3 ethoxy units), SR601 (bisphenol A diacrylate with 4 ethoxy units) and SR602 (bisphenol A diacrylate with 10 ethoxy units) and CD9038 (bisphenol A diacrylate with 30 ethoxy units). Corresponding methacrylates can also be used.

It is, of course, possible to use more than one of the above-mentioned ethylenically unsaturated monomers. If the photopolymerizable composition of the present invention includes a second type of ethylenically unsaturated monomer, it can also contain a second type of photoinitiator system. This would allow the photopolymerizable composition to be imaged at two different wavelengths, which can be desirable in some applications.

Furthermore, the photopolymerizable composition can include a third type of ethylenically unsaturated monomer. This ethylenically unsaturated monomer can be used, e.g., to control the viscosity of the photopolymerizable composition. An example thereof is 2-phenoxyethyl acrylate.

The at least one ethylenically unsaturated monomer is included in the photopolymerizable compositions of the present invention so that the amount of the components adds up to 100 weight-% based on the total weight of the photopolymerizable composition.

### Component (ii): Photoinitiator system

The photoinitiator system is not particularly limited. Any photoinitiator system that is conventionally used in photopolymerizable compositions, e.g., for refractive index imaging, can be employed. The specific photoinitiator system will usually be chosen based on the specific ethylenically unsaturated monomer selected and/or the type of irradiation to be employed.

Typically the photoinitiator system will include a photoinitiator and optionally a co-initiator.

The photoinitiator is usually a UV or a VIS photoinitiator, preferably a UV photoinitiator. Typically the absorbance of the photoinitiator will be in the range of 266 to 700 nm, preferably 350 to 680 nm, with the peak absorbances more preferably being in the range of 450 to 650 nm.

Suitable photoinitiators include the substituted or unsubstituted polynuclear quinones which are compounds having two intracyclic carbon atoms in a conjugated carbocyclic ring system, e.g., 9,10-anthraquinone 1-chloroanthraquinone, 2-chloroanthraquinone, 2-methylanthraquinone, 2-ethylanthraquinone, 2-tert-butylanthraquinone, octamethylanthraquinone, 1,4-naphthoquinone, 9,10-phenanthrenequinone, 1,2-benzanthraquinone, 2,3-benzanthraquinone, 2-methyl-1,4-naphthoquinone, 2,3-dichloronaphthoquinone, 1,4-dimethylanthraquinone, 2,3-dimethylanthraquinone, 2-phenylanthraquinone, 2-3-diphenylanthraquinone, sodium salts of anthraquinone alpha-sulfonic acid, 3-chloro-2-methylanthraquinone, retenequinone, 7,8,9,10-tetrahydronaphthacenequinone, and 1,2,3,4-tetrahydrobenz(a)anthracene-7,12-dione. Other photoinitiators which are also useful are described in U.S. Patent 2,760,863 and include vicinal ketaldonyl alcohols, such as benzoin, pivaloin, acyloin ethers, e.g., benzoin methyl and ethyl ethers; α-hydrocarbon-substituted aromatic acyloins, including α-methylbenzoin; α-allylbenzoin and α-phenylbenzoin. Photoreducible dyes and reducing agents, such as those disclosed in U.S. Patents 2,850,445; 2,875,047; 3,097,096; 3,074,974; 3,097,097; 3,145,104 and 3,579,339; as well as dyes of the phenazine, oxazine, and quinone classes; Michler's ketone; benzophenone; 2,4,5-triphenylimidazolyl dimers with hydrogen donors, and mixtures thereof as described in U.S. Patents 3,427,161; 3,479,185; 3,549,367; 4,311,783; 4,622,286; and 3,784,557 can be used as initiators. A useful discussion of dye sensitized photopolymerization can be found in "Dye Sensitized Photopolymerization" by D. F. Eaton in Adv. in Photochemistry, Vol. 13, D. H. Volman, G. S. Hammond, and K. Gollinick eds., Wiley-Interscience, New York, 1986, pp. 427-487. Similarly the cyclohexadienone compounds of U.S. Patent No. 4,341,860 are useful as initiators.

Co-initiators (sensitizers) useful with the photoinitiators include methylene blue and those disclosed in U.S. Patents 3,554,753; 3,563,750; 3,563,751; 3,647,467; 3,652,275; 4,162,162; 4,268,667; 4,351,893: 4,454,218; 4,535,052; and 4,565,769. The co-initiator is preferably active in the UV-region, e.g. from 266 to 480 nm.

A particularly preferred photoinitiator system includes a phenazine dye as a co-initiator. An example of a suitable phenazine dye is 3,7-diamino-2,8-dimethyl-5-phenyl-phenazinium chloride (Safranin O). With phenazine dye-based co-initiators the photoinitiator will typically be a borate compound such as member of the CGI series, which are available from Ciba Specialty Chemicals. Preferred examples are CGI 909 and CGI 7460.

In an alternative embodiment the photoinitiator system comprises a co-initiator based on fluorone or pyronin Y derivatives, such as those described in US-A-5,451,343 and US-A-5,395,862. Photoinitiators for this type of photoinitiator system are preferably amines, borates, nitrohalomethanes, diazosulfones, onium salts, ferrocenium salts and thiapyrylium salts. Particularly preferred photoinitiators are amines and borates, even more preferred are borates such as tetra-C₁₋₄-alkylammonium triphenyl-C₁₋₄-alkyl borate, e.g., tetramethylammonium triphenylbutyl borate. Such photoinitiator systems are available, e.g., from Spectra Group Ltd. under the trade designations H-Nu 470, H-Nu 535 und H-Nu 635.

The co-initiator is typically present in an amount of 0.15 to 0.5 weight-%, preferably about 0.3 weight-%, based on the total weight of the photopolymerizable composition. If present, the photoinitiator is typically included in an amount of 0.015 to 0.1 weight-%, preferably about 0.05 weight-%, based on the total weight of the photopolymerizable composition.

### Component (iii): Organic component

The organic component which is the third component of the photopolymerizable compositions of the present invention is selected from the group consisting of castor oil, palm kernel oil, coconut oil and combinations thereof. The organic component preferably should exhibit an absolute value of the difference in refractive index between the ethylenically unsaturated monomer and the organic component of at least 0.065.

The organic component used in the process according to the invention is a triglyceride. Triglycerides are esters of glycerine in which the hydroxy groups have been esterified by identical or different carboxylic acids. Suitable carboxylic acids can, e.g., have 6 to 30 carbon atoms, preferably 6 to 24 carbon atoms, even more preferably 6 to 18 carbon atoms. Examples of preferred carboxylic acids are ricinoleic acid, stearic acid, palmitic acid, lauric acid, myristic acid, oleic acid and linoleic acid and combinations thereof. Typically the triglycerides will be employed in the form of natural fats or oils and will thus contain a mixture of various triglycerides. Preferably the mixture will contain a major amount (e.g. 50 wt.-% or more) of triglycerides based on carboxylic acids having 12 to 18 carbon atoms. Preferred oils are castor oil, palm kernel oil, coconut oil, and combinations thereof. A preferred embodiment of the invention is a mixture of 20 to 80 wt.-%, preferably 40 to 60 wt.-%, castor oil and 80 to 20 wt.-%, preferably 60 to 40 wt.-%, palm kernel oil.

The organic component is preferably present in an amount of 3 to 10 weight-%, preferably 4.0 to 8.0 weight-%, based on the total weight of the photopolymerizable composition.

As explained above, the absolute value of the difference in refractive index between the at least one ethylenically unsaturated monomer and the at least one organic component is preferably at least 0.065. The difference in refractive index can be determined by measuring the refractive index of the pure ethylenically unsaturated monomer and the refractive index of the pure organic component. The difference is then determined and multiplied by a factor of 0.65 to account for the deviation between the theoretical value and the experimentally observed value. If more than one ethylenically unsaturated monomer is employed then the refractive index of the ethylenically unsaturated monomer is determined by measuring the refractive indexes of each of the pure ethylenically unsaturated monomers and calculating a weight-averaged mean. For example, if monomer 1 is employed in twice the amount of monomer 2, its refractive index will be weighted by a factor of 2. The same procedure is followed if more than one organic component is employed.

### Optional components

In addition to the above-mentioned components, the photopolymerizable compositions of the present invention can include additional components that improve or modify the properties of the photopolymerizable composition. Examples of such additional components are surfactants and plasticizers. Typical surfactants are fluorosurfactants such as those available under the trade designations Schwego-Fluor (available from Schwegmann) and Fluorad series (available from 3M Company). The additional components, such as the surfactants, are preferably present in an amount of 0 to 5 weight-%, preferably 0.15 to 0.3 weight-%, based on the total weight of the photopolymerizable composition.

Organic solvents can be used in minor amounts, e.g., to dissolve the photoinitiator.

### Photosensitive element

The photopolymerizable compositions are typically provided in the form of a photosensitive element, in which the photopolymerizable composition is present in the form of a layer on a substrate. The substrate is not particularly limited and any substrate that is typically employed in refractive index imaging can be used. Typically the substrate will be a polymeric film, which is preferably transparent to the irradiation employed. Specific substrates include polyethylene terephthalate film, e.g., resin-subbed polyethylene terephthalate film, flame or electrostatic discharge treated polyethylene terephthalate film, glass, cellulose acetate film, polyethylene film and the like. The thickness of the layer of photopolymerizable composition is not particularly limited either and will depend on the ultimate use of the photosensitive element. Usual thicknesses are from 5 to 20 µm, preferably 5 to 15 µm.

In addition to the photopolymerizable composition and the substrate, the photosensitive element can include additional layers and/or components, which will be selected according to the end use of the photosensitive element. An example of such an additional component is a cover sheet.

### Preparation of the photopolymerizable composition

The photopolymerizable composition can be easily prepared by mixing the components. The components can all be mixed together or individual components can be premixed before other components are added. The ultimate mixing sequence should be determined depending on the individual components chosen.

### Process for preparing a refractive index image

The photopolymerizable compositions of the present invention are especially suitable for preparing refractive index images, such as holograms, which include transmission and reflection holograms.

Such a refractive index image can be prepared by exposing the photopolymerizable composition (e.g., in the form of a photosensitive element) to modulated actinic radiation and subsequently homogeneously treating the photopolymerizable composition with UV irradiation.

The method of exposing the photopolymerizable composition to modulated actinic radiation to form a refractive index image is known in the art and can easily be conducted by a skilled person. Typically the modulated actinic radiation will be provided by a laser. If desired, the imaging of the photopolymerizable composition can be conducted at enhanced temperatures, such as a temperature of 30 to 60 °C, preferably 40 to 50 °C.

In a final step of the process the imaged photopolymerizable composition is homogeneously treated with UV irradiation. This step "fixes" the prepared image and avoids that subsequently changes occur, e.g. by subsequent polymerization of unreacted monomers. By using this step the conventional heat treatment step, which is employed in the prior art, can be avoided. This is advantageous because the UV treatment step is much shorter and cost effective. Furthermore, in contrast to the prior art the restriction to non-heat sensitive materials for the photosensitive elements is not necessary.

In a typical embodiment, the UV treatment is conducted by subjecting the photosensitive element to a flash of UV irradiation. The wavelength of the UV treatment will depend on the components employed in the photopolymerizable composition and is typically 266 nm to 450 nm. The duration of the UV treatment will depend on the amount of fixing required and can typically be 0.25 to 10 seconds, preferably 0.25 to 5 seconds. The duration can be reduced if UV lamps of higher intensity are used.

The invention will now be illustrated by the following example, which however should not be construed as limiting.

### Example

The photopolymerizable composition of the example had the following composition.

| Component | Amount [wt.-%] |
|---|---|
| Sartomer SR349 | 91.93 |
| Safranin O solution (3% in ethanol) | 0.03 |
| CGI 7460 | 0.34 |
| Castor oil | 3.75 |
| Palm kernel oil | 3.75 |
| Schwego-Fluor 8038 | 0.2 |

The two oils were mixed, followed by the addition of Sartomer SR349. Subsequently CGI 7460, then Safranin O and finally the surfactant Schwego-Fluor 8038 were added while stirring was continued. If the mixture is not homogeneous, it can be optionally heated, e.g., for 5 minutes at 50 to 80 °C.

The photopolymerizable composition was coated between two glass plates which were separated by a 7 µm thick spacer. It was then imaged with laser light having a wavelength of 532 nm (100 mW, 5 seconds). Finally the complete photopolymerizable composition was fixed using a Xe-Hg lamp (wavelength: 365 nm, 200 Watt, 1 second, 3 W/cm²).

The resultant holographic image had a very good quality and was stable. It had a diffraction efficiency of 86%.

As a comparison, the above experiment was repeated in an identical manner with the exception that the two oils were not included in the photopolymerizable composition. The resultant holographic image was unstable and disappeared upon fixation.

## Claims

1. Binder-free photopolymerizable composition comprising:
(i) at least one ethylenically unsaturated monomer;
(ii) a photoinitiator system; and
(iii) at least one organic component;
wherein the at least one ethylenically unsaturated monomer has the general formula 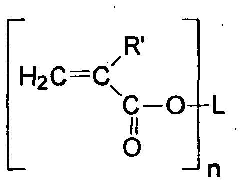 wherein
n is 2 to 4;
R' is hydrogen or CH₃; and
L is 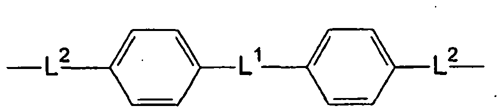 wherein the phenyl rings are optionally substituted by one or more substituents selected from the group consisting of halogen, C₁₋₄-alkyl, C₁₋₄-alkoxy or hydroxy;
L¹ is a covalent bond or a straight or branched C₁₋₄ alkylene group;
L² is a covalent bond, a straight or branched C₁₋₄ alkylene group optionally substituted by hydroxy, or -[L³-O]ₘ- with L³ being a C₁₋₄ alkylene group and m being 1 to 40;
wherein the at least one organic component is selected from the group consisting of castor oil, palm kernel oil, coconut oil and combinations thereof.

2. The photopolymerizable composition according to claim 1 wherein the photopolymerizable composition comprises one ethylenically unsaturated monomer.

3. The photopolymerizable composition according to claim 1 wherein the photopolymerizable composition comprises two or more ethylenically unsaturated monomers.

4. The photopolymerizable composition according to any of the preceding claims wherein the at least one ethylenically unsaturated monomer is a di- or tri-(meth)acrylate with 2 to 30 C₁₋₄ alkoxy units.

5. The photopolymerizable composition according to claim 4 wherein the at least one ethylenically unsaturated monomer is an bisphenol A di- or tri-(meth)acrylate with 2 to 30 C₁₋₄ alkoxy units.

6. The photopolymerizable composition according to claim 1 wherein n is 2 or 3; L¹ is -CH₂- or -C(CH₃)₂-; L² is -[L³-O]ₘ-; L³ is ethylene or propylene and m is 2 to 30.

7. The photopolymerizable composition according to any of the preceding claims wherein the photoinitiator system comprises a photoinitiator and a co-initiator.

8. The photopolymerizable composition according to claim 7 wherein the co-initiator is present in an amount of 0.15 to 0.5 weight-% based on the total weight of the photopolymerizable composition.

9. The photopolymerizable composition according to claim 7 or 8 wherein photoinitiator is present in an amount of 0.015 to 0.1 weight-% based on the total weight of the photopolymerizable composition.

10. The photopolymerizable composition according to any of the preceding claims wherein the at least one organic component is present in an amount of 3 to 10 weight-% based on the total weight of the photopolymerizable composition.

11. The photopolymerizable composition according to claim 1 wherein the at least one organic component is a mixture of 20 to 80 wt. -% castor oil and 80 to 20 wt.-% palm kernel oil.

12. The photopolymerizable composition according to claim 1 wherein the absolute value of the difference in refractive index between the at least one ethylenically unsaturated monomer and the at least one organic component is at least 0.065.

13. A process for preparing a refractive index image comprising the steps of:
(a) providing a photosensitive element comprising a substrate and a layer of a photopolymerizable composition comprising:
(i) at least one ethylenically unsaturated monomer;
(ii) a photoinitiator system; and
(iii) at least one triglyceride;
(b) exposing the photopolymerizable composition to modulated actinic radiation; and
(c) homogeneous treatment of the photopolymerizable composition with UV irradiation.

14. The process according to claim 13 wherein the refractive index image is a hologram.

15. The process according to claim 14 wherein the hologram is a transmission or reflection hologram.

## Patentansprüche

1. Bindemittelfreie photopolymerisierbare Zusammensetzung, umfassend:
(i) mindestens ein ethylenisch ungesättigtes Monomer;
(ii) ein Photoinitiatorsystem; und
(iii) mindestens eine organische Komponente;
wobei das mindestens eine ethylenisch ungesättigte Monomer die allgemeine Formel hat 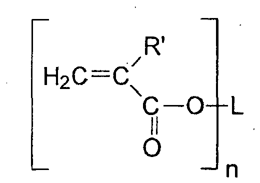 wobei
n 2 bis 4 ist;
R' Wasserstoff oder CH₃ ist; und
L 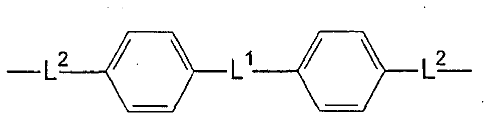 ist,
wobei die Phenylringe optional substituiert sind mit einem oder mehreren Substituenten, ausgewählt aus der Gruppe, bestehend aus Halogen, C₁₋₄-Alkyl, C₁₋₉₋Alkoxy oder Hydroxy;
L¹ eine kovalente Bindung oder eine geradkettige oder verzweigte C₁₋₄-Alkylengruppe ist;
L² eine kovalente Bindung, eine geradkettige oder verzweigte C₁₋₄-Alkylengruppe, die optional mit Hydroxy substituiert ist, oder -[L³-O]ₘ-, wobei L³ eine C₁₋₄-Alkylengruppe ist und m 1 bis 40 ist, ist;
wobei die mindestens eine organische Komponente ausgewählt ist aus der Gruppe, bestehend aus Rizinusöl, Palmkernöl, Kokosnussöl und Kombinationen davon.

2. Photopolymerisierbare Zusammensetzung gemäß Anspruch 1, wobei die photopolymerisierbare Zusammensetzung ein ethylenisch ungesättigtes Monomer umfasst.

3. Photopolymerisierbare Zusammensetzung gemäß Anspruch 1, wobei die photopolymerisierbare Zusammensetzung zwei oder mehr ethylenisch ungesättigte Monomere umfasst.

4. Photopolymerisierbare Zusammensetzung gemäß einem der vorangehenden Ansprüche, wobei das mindestens eine ethylenisch ungesättigte Monomer ein Di- oder Tri(meth)acrylat mit 2 bis 30 C₁₋₄-Alkoxyeinheiten ist.

5. Photopolymerisierbare Zusammensetzung gemäß Anspruch 4, wobei das mindestens eine ethylenisch ungesättigte Monomer ein Bisphenol A-di- oder -tri(meth)acrylat mit 2 bis 30 C₁₋₄-Alkoxyeinheiten ist.

6. Photopolymerisierbare Zusammensetzung gemäß Anspruch 1, wobei n 2 oder 3 ist; L¹ -CH₂- oder -C(CH₃)₂- ist; L² -[L³-O]ₘ-ist; L³ Ethylen oder Propylen ist und m 2 bis 30 ist.

7. Photopolymerisierbare Zusammensetzung gemäß einem der vorangehenden Ansprüche, wobei das Photoinitiatorsystem einen Photoinitiator und einen Co-Initiator umfasst.

8. Photopolymerisierbare Zusammensetzung gemäß Anspruch 7, wobei der Co-Initiator in einer Menge von 0,15 bis 0,5 Gewichts-%, basierend auf dem Gesamtgewicht der photopolymerisierbaren Zusammensetzung, vorliegt.

9. Photopolymerisierbare Zusammensetzung gemäß Anspruch 7 oder 8, wobei der Photoinitiator in einer Menge von 0,015 bis 0,1 Gewichts-%, basierend auf dem Gesamtgewicht der photopolymerisierbaren Zusammensetzung, vorliegt.

10. Photopolymerisierbare Zusammensetzung gemäß einem der vorangehenden Ansprüche, wobei die mindestens eine organische Komponente in einer Menge von 3 bis 10 Gewichts-%, basierend auf dem Gesamtgewicht der photopolymerisierbaren Zusammensetzung, vorliegt.

11. Photopolymerisierbare Zusammensetzung gemäß Anspruch 1, wobei die mindestens eine organische Komponente eine Mischung aus 20 bis 80 Gew.-% Rizinusöl und 80 bis 20 Gew.-% Palmkernöl ist.

12. Photopolymerisierbare Zusammensetzung gemäß Anspruch 1, wobei der absolute Wert der Differenz im Brechungsindex zwischen dem mindestens einen ethylenisch ungesättigten Monomer und der mindestens einen organischen Komponente mindestens 0,065 ist.

13. Verfahren zur Herstellung eines Brechungsindexbildes, das die Schritte umfasst:
(a) Bereitstellen eines photosensitiven Elements, das ein Substrat und eine Schicht einer photopolymerisierbaren Zusammensetzung, umfassend:
(i) mindestens ein ethylenisch ungesättigtes Monomer;
(ii) ein Photoinitiatorsystem; und
(iii) mindestens ein Triglycerid;
umfasst;
(b) Aussetzen der photopolymerisierbaren Zusammensetzung modulierter aktinischer Strahlung; und
(c) homogene Behandlung der photopolymerisierbaren Zusammensetzung mit UV-Strahlung.

14. Verfahren gemäß Anspruch 13, wobei das Brechungsindexbild ein Hologramm ist.

15. Verfahren gemäß Anspruch 14, wobei das Hologramm ein Transmissions- oder Reflexionshologramm ist.

## Revendications

1. Une composition photopolymérisable sans liant, comprenant:
(i) au moins un monomère éthyléniquement insaturé;
(ii) un système de photo-initiateur et
(iii) au moins un composant organique;
dans laquelle ledit au moins un monomère éthyléniquement insaturé possède la formule générale 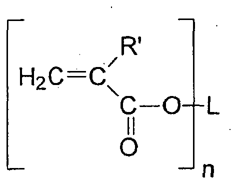 dans laquelle
n est de 2 à 4;
R' est un atome d'hydrogène ou CH₃ et
L est 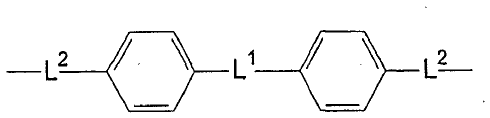 dans laquelle les cycles phényle sont éventuellement substitués par un ou plusieurs substituent(s) choisi(s) parmi le groupe consistant en halogène, C₁₋₄-alkyle, C₁₋₄-alcoxy ou hydroxyle;
L¹ est une liaison covalente ou un groupe C₁₋₄-alkylène linéaire ou ramifié;
L² est une liaison covalente, un groupe C₁₋₄-alkylène linéaire ou ramifié éventuellement substitué par un groupe hy-droxyle ou -[L³-O]ₘ-, L³ étant un groupe C₁₋₄-alkylène et m étant 1 à 40;
dans laquelle ledit au moins un composant organique est choisi dans le groupe constitué par l'huile de ricin, l'huile de palmiste, l'huile de noix de coco et leurs combinaisons.

2. La composition photopolymérisable selon la revendication 1, la composition photopolymérisable comprenant un monomère éthyléniquement insaturé.

3. La composition photopolymérisable selon la revendication 1, la composition photopolymérisable comprenant deux ou plusieurs monomères éthyléniquement insaturés.

4. La composition photopolymérisable selon l'une quelconque des revendications précédentes, dans laquelle ledit au moins un monomère éthyléniquement insaturé est un di- ou tri-(méth)acrylate avec de 2 à 30 unités alcoxy en C₁₋₄.

5. La composition photopolymérisable selon la revendication 4, dans laquelle ledit au moins un monomère éthyléniquement insaturé est un di- ou tri-(méth)acrylate de bisphénol A avec de 2 à 30 unités alcoxy en C₁₋₄.

6. La composition photopolymérisable selon la revendication 1, dans laquelle m est 2 ou 3; L¹ est -CH₂- ou -C(CH₃)₂-; L² est -[L³-O]ₘ-; L³ étant l'éthylène ou le propylène et m étant de 2 à 30.

7. La composition photopolymérisable selon l'une quelconque des revendications précédentes, dans laquelle le système de photo-initiateur comprend un photo-initiateur et un co-initiateur.

8. La composition photopolymérisable selon la revendication 7, dans laquelle le co-initiateur est présent en une quantité de 0,15 à 0,5% en poids par rapport au poids total de la composition photopolymérisable.

9. La composition photopolymérisable selon la revendication 7 ou 8, dans laquelle le photo-initiateur est présent en une quantité de 0,015 à 0,1% en poids par rapport au poids total de la composition photopolymérisable.

10. La composition photopolymérisable selon l'une quelconque des revendications précédentes, dans laquelle ledit au moins un composant organique est présent en une quantité de 3 à 10% en poids par rapport au poids total de la composition photopolymérisable.

11. La composition photopolymérisable selon la revendication 1, dans laquelle ledit au moins un composant organique est un mélange de 20 à 80% en poids d'huile de ricin et de 80 à 20% en poids d'huile de palmiste.

12. La composition photopolymérisable selon la revendication 1, dans laquelle la valeur absolue de la différence d'indice de réfraction entre ledit au moins un monomère éthyléniquement insaturé et ledit au moins un composant organique est au moins 0,065.

13. Procédé de préparation d'une image de l'indice de réfraction comprenant les étapes consistant à:
(a) fournir un élément photosensible comprenant un substrat et une couche d'une composition photopolymérisable, comprenant:
(i) au moins un monomère éthyléniquement insaturé;
(ii) un système de photo-initiateur et
(iii) au moins un triglycéride;
(b) exposer la composition polymérisable à un rayonnement actinique;
(c) un traitement homogène de la composition photopolymérisable avec une irradiation UV.

14. Le procédé selon la revendication 13, dans lequel l'image de l'indice de réfraction est un hologramme.

15. Le procédé selon la revendication 14, dans lequel l'hologramme est un hologramme de transmission ou de réflexion.
